Europäisches Patentamt

(19) European Patent Office

Office européen des brevets

(11) Numéro de publication : **0 053 974**
**B1**

(12) **FASCICULE DE BREVET EUROPÉEN**

(45) Date de publication du fascicule du brevet :
04.07.84

(51) Int. Cl.³ : **H 01 S   3/13, H 01 S   3/10**

(21) Numéro de dépôt : **81401901.4**

(22) Date de dépôt : **01.12.81**

(54) **Dispositif de protection d'une diode laser.**

(30) Priorité : **09.12.80 FR 8026074**

(43) Date de publication de la demande :
**16.06.82 Bulletin 82/24**

(45) Mention de la délivrance du brevet :
**04.07.84 Bulletin 84/27**

(84) Etats contractants désignés :
**DE GB**

(56) Documents cités :
**DE-A- 2 847 182**
**DE-A- 2 923 683**
**FR-A- 2 448 274**
**US-A- 4 009 385**

(73) Titulaire : **THOMSON-CSF**
**173, Boulevard Haussmann**
**F-75379 Paris Cedex 08 (FR)**

(72) Inventeur : **Claverie, Claude**
**THOMSON-CSF SCPI 173, Bld Haussmann**
**F-75379 Paris Cedex 08 (FR)**
Inventeur : **Eouzan, Jean-Yves**
**THOMSON-CSF SCPI 173,. Bld Haussmann**
**F-75379 Paris Cedex 08 (FR)**

(74) Mandataire : **Wang, Pierre et al**
**THOMSON-CSF SCPI 173, Bld Haussmann**
**F-75379 Paris Cedex 08 (FR)**

EP 0 053 974 B1

## Description

La présente invention concerne un dispositif de protection d'une diode laser, et plus particulièrement un dispositif de protection d'une diode laser utilisée dans la tête optique d'un système vidéodisque.

La diode laser utilisée dans la tête optique d'un système vidéodisque est alimentée à la fois par un courant continu de polarisation et par un courant variable porteur d'informations, l'alimentation en courant continu ayant pour but de fixer un point de polarisation autour duquel se produisent ensuite des variations liées aux opérations de lecture et d'écriture d'informations sur le vidéodisque. Un tel montage destiné au réglage du courant modulateur d'une diode laser utilisée comme émetteur d'un système de transmission de signal a fait l'objet d'une description dans le document DE-A-2 847 182.

Cette diode laser est classiquement associée à un système de contre-réaction optoélectronique, dont la branche de retour comporte une photodiode de contre-réaction et dont la branche directe comporte un amplificateur de contre-réaction, de manière à asservir la puissance optique issue du laser et ceci malgré les évolutions de la caractéristique de transfert de la diode. En effet, la caractéristique de transfert de la diode peut évoluer suivant la température ou le vieillissement. Par ailleurs la caractéristique de transfert de la diode est telle qu'au-delà d'un certain seuil, cette caractéristique est presque verticale. Dans ces conditions, une erreur dans la commande d'alimentation de la diode laser risque de se traduire par une destruction immédiate du laser.

Une telle situation se produit notamment lorsque le courant continu de polarisation apparaît avec un certain retard par rapport au courant porteur d'informations. En effet la diode laser n'étant pas correctement polarisée lorsqu'apparaît le courant porteur d'informations, le signal injecté dans l'amplificateur de contre-réaction par la photodiode de contre-réaction est alors très faible par rapport au signal porteur d'informations également injecté dans l'amplificateur. Or c'est la différence entre ces deux signaux, par ailleurs fortement amplifiée par l'amplificateur de contre-réaction, qui se trouve appliquée à la diode laser. On voit donc immédiatement qu'il y a un risque de destruction du laser dans une telle configuration.

La présente invention a pour objet un dispositif de protection de la diode laser de structure extrêmement simple permettant de s'assurer de la polarisation de la diode laser avant toute injection d'un signal porteur d'informations dans cette diode.

L'invention propose également une structure d'amplificateur de contre-réaction ainsi qu'un agencement relatif de cet amplificateur et du circuit de protection, permettant d'obtenir une pleine efficacité du dispositif de protection conforme à l'invention.

Selon l'invention le dispositif de protection d'une diode laser alimentée par une source d'un courant continu de polarisation et par une source d'un courant variable porteur d'information, les deux sources de courant étant montées en parallèle, caractérisé en ce que la source de courant continu peut être branchée ou débranchée par un interrupteur ; une résistance variable étant arrangée en parallèle avec la source de courant porteur d'information ; ladite résistance variable prenant une valeur nulle lorsque l'interrupteur est ouvert, une valeur pratiquement infinie lorsque l'interrupteur est fermé et une valeur croissant ou décroissant progressivement entre ces deux valeurs extrêmes selon que l'interrupteur passe de l'état ouvert à l'état fermé ou de l'état fermé à l'état ouvert.

Les objets et caractéristiques de la présente invention apparaîtront plus clairement de la lecture de la description suivante d'exemples de réalisation, ladite description étant faite en relation avec les dessins annexés dans lesquels :

la figure 1 est un schéma de principe du dispositif de protection conforme à l'invention et de son environnement ;

la figure 2 est un schéma montrant un premier exemple de réalisation d'un dispositif de protection conforme à l'invention ;

la figure 3 est un schéma montrant un second exemple de réalisation d'un dispositif de protection conforme à l'invention ;

la figure 4 est un schéma montrant un exemple de réalisation d'un amplificateur de contre-réaction destiné à coopérer avec un dispositif de protection conforme à l'invention

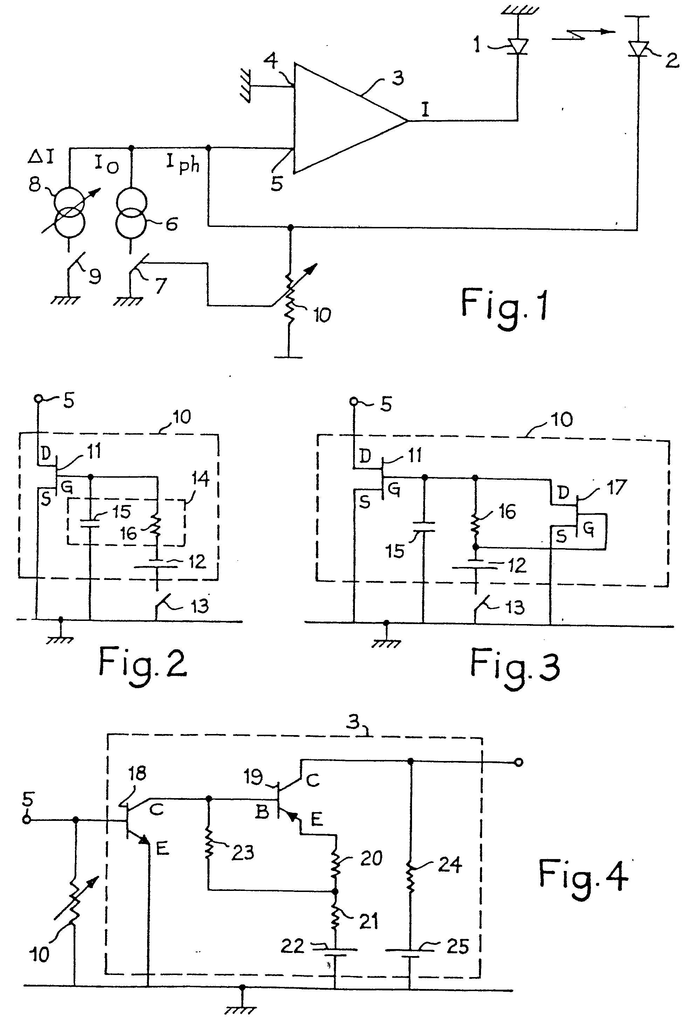

Des éléments identiques sur les figures 1 à 4 portent des références identiques.

Sur la figure 1 on a représenté une diode laser 1 alimentée par un courant I fourni par un système de contre-réaction comportant une photodiode de contre-réaction 2 et un amplificateur de contre-réaction 3. L'amplificateur de contre-réaction 3 a une première entrée 4 reliée à un premier pôle d'une source de tension continue de référence (non représentée sur la figure) et reçoit sur une seconde entrée 5 la superposition d'un courant continu de polarisation $I_o$ fourni par une source de courant continu mise en service au moyen d'un interrupteur 7, d'un courant d'information $\Delta I$ fourni par une source de courant variable 8 mise en service au moyen d'un interrupteur 9, et d'un courant photo-détecté I pH fourni par la photodiode de contre-réaction.

Un dispositif de protection 10 est inséré entre l'entrée 5 de l'amplificateur de contre-réaction 3 et un second pôle de la source de tension continue de référence. Le dispositif de protection 10 consiste en une résistance présentant une valeur théoriquement nulle (c'est-à-dire pratiquement très faible) lorsque l'interrupteur 7 est ouvert, une valeur théoriquement infinie (c'est-à-dire pratiquement très grande) lorsque l'interrupteur 7 est fermé, une valeur croissant progressivement entre ces deux valeurs extrêmes lorsque l'interrupteur 7 passe de l'état ouvert à l'état fermé, et une valeur décroissant progressivement entre ces deux valeurs extrêmes lorsque l'interrupteur 7 passe de l'état fermé à l'état ouvert.

Ces variations de la résistance 10 sont symbolisées sur la figure 1 à l'aide d'une flèche brisée dont une extrémité est reliée à la partie mobile de l'interrupteur 7 et dont une autre extrémité est reliée à la résistance 10.

Les bornes des interrupteurs 7 et 9 qui ne sont pas reliées aux sources de courant 6 et 8 sont reliées au premier pôle de la source de tension continue de référence, la borne de la diode laser 1 qui n'est pas reliée à la sortie de l'amplificateur 3 est reliée au premier pôle de la source de tension contenue de référence, et la borne de la photodiode de contre-réaction qui n'est pas reliée à l'entrée 5 de l'amplificateur 3 est reliée au second pôle de la source de tension continue de référence.

Lorsqu'on ferme l'interrupteur 9 alors que l'interrupteur 7 est ouvert, le courant ΔI est dérivé dans la résistance 10 qui présente alors une résistance nulle.

Lorsqu'on ferme l'interrupteur 9 alors que l'interrupteur 7 est fermé, le courant ΔI est injecté vers la diode laser (à travers le système de contre-réaction) car la résistance 10 présente alors une valeur infinie.

Lorsqu'on ferme l'interrupteur 9 alors que l'interrupteur 7 passe de l'état ouvert à l'état fermé, le courant ΔI est progressivement injecté vers la diode laser (à travers le système de contre-réaction) car la résistance 10 présente alors une valeur croissant progressivement entre une valeur nulle et une valeur infinie.

Lorsqu'on ferme l'interrupteur 9 alors que l'interrupteur 7 passe de l'état fermé à l'état ouvert, le courant ΔI est progressivement dérivé dans la résistance variable 10 car la résistance 10 présente alors une valeur décroissant progressivement entre une valeur infinie et une valeur nulle.

On est donc assuré que dans tous les cas de figures, la polarisation de la diode laser précède l'injection du courant porteur d'informations dans cette même diode. le laser se trouve ainsi protégé de manière très efficace.

Sur la figure 2, la résistance variable 10 comporte un premier transistor à effet de champ 11, dont le drain D est connecté à l'entrée 5 de l'amplificateur 3, et dont la source S est connectée au premier pôle de la source de tension continue de référence.

La résistance variable 10 comporte également une première source de tension continue de polarisation 12, dont un premier pôle est connecté au premier pôle de la source de tension continue de référence via un interrupteur 13.

L'interrupteur 13 est destiné à commander l'établissement et la coupure de la tension continue de polarisation fournie par la source 12. les interrupteurs 7 et 13 sont commandés simultanément.

La polarité de la source 12 et la valeur de la tension qu'elle délivre sont telles que le transistor 11 est saturé lorsque l'interrupteur 13 est ouvert, et bloqué lorsque l'interrupteur 13 est fermé.

La résistance variable 10 comporte également un circuit de temporisation 14, inséré entre la source de tension continue de polarisation 12 et la grille G du premier transistor à effet de champ 11.

Le circuit de temporisation 14 comporte un condensateur 15 dont une première borne est connectée à la grille G du transistor 11, et dont une deuxième borne est connectée au premier pôle de la source de tension continue de référence et une résistance 16, dont une première borne est connectée à la grille G du transistor 11 et dont une seconde borne est connectée au second pôle de la source de tension continue de polarisation 12.

Les interrupteurs 7 et 13 étant commandés simultanément, le transistor 11 reste à l'état saturé tant que la source de courant continu de polarisation 6 n'est pas mise en service. Ce transistor présente alors une résistance très faible (pratiquement nulle) ce qui permet de dériver dans la résistance 10 tout courant porteur d'informations ΔI qui surviendrait à ce moment.

Lorsque la source de courant continu de polarisation 6 est mise en service, le transistor 11 passe de l'état saturé à l'état bloqué, et ce passage se fait de manière progressive en raison de la présence du circuit de temporisation 14. Lorsque le circuit de temporisation 14 est comme ici du type « RC », la tension entre la grille G et la source S du transistor 11, qui est aussi la tension aux bornes du condensateur 15, varie de manière exponentielle à partir de la valeur « 0 » pour tendre asymptomatiquement vers la valeur de la source de tension continue de polarisation 12.

Ainsi, lors de l'établissement du courant continu fourni par la source de courant continu de polarisation 6, la résistance variable 10 passe progressivement d'une valeur nulle (transistor 11 saturé) à une valeur théoriquement infinie, c'est-à-dire pratiquement très grande (transistor 11 bloqué), ce qui permet d'injecter progressivement dans la diode laser tout courant porteur d'information qui surviendrait à ce moment.

Lors de la coupure du courant continu fourni par la source de courant continu de polarisation, c'est-à-dire lors de la mise hors service de la source 6, c'est le phénomène inverse qui se produit, à savoir une dérivation progressive dans la résistance 10 d'un courant ΔI qui surviendrait à ce moment.

Le dispositif de protection représenté sur la figure 3 diffère de celui représenté sur la figure 2 uniquement par l'adjonction d'un second transistor à effet de champ 17 dont le drain D est connecté à la grille G du transistor 11, dont la source S est connectée à la source S du transistor 11 et dont la grille G est connectée au second pôle de la source de tension continue de polarisation 12.

La polarité de la source 12 et la valeur de la tension qu'elle délivre sont telles que le transistor 17 est saturé lorsque l'interrupteur 13 est ouvert, et bloqué lorsque l'interrupteur 13 est fermé. Le transistor 17, qui se comporte comme une résistance variable branchée en parallèle sur le condensateur 15, a pour effet, lors de la coupure du courant continu d'alimentation $I_o$, de court-circuiter rapidement le condensateur 15, ce qui a pour incidence de porter à saturation très rapidement le transistor 11. La diode laser se trouve ainsi protégée de manière encore plus efficace lors de la coupure de son courant continu de polarisation $I_o$. Le transistor 17 permet de réinitialiser rapidement le circuit de temporisation, préparant ainsi une nouvelle mise sous tension.

L'amplificateur de contre-réaction 3 représenté à la figure 4 se compose de « n » étages de générateurs-amplificateurs de courant, montés en cascade, « n » étant égal à 2 dans le cadre de l'exemple de réalisation décrit.

On entend par générateur-amplificateur de courant un transistor bipolaire monté en émetteur commun. On dit de plusieurs générateurs-amplificateurs de courant qu'ils sont montés en cascade lorsque la base de l'un d'eux est reliée au collecteur de celui qui le précède de sorte que le blocage de l'un d'eux entraîne le blocage de celui qui le suit si les transistors sont alternativement de type PNP-NPN... etc...

Le premier étage, c'est-à-dire le premier générateur-amplificateur de courant, comporte un premier transistor bipolaire 18 dont la base B constitue l'entrée 5 de l'amplificateur, et dont l'émetteur E est connecté au premier pôle de la source de tension continue de référence.

Le second étage, c'est-à-dire le second générateur-amplificateur de courant, comporte un second transistor bipolaire 19 dont la base B est reliée au collecteur C du transistor 18, dont le collecteur C constitue la sortie de l'amplificateur, et dont l'émetteur E est relié au premier pôle de la source de tension continue de référence via une première résistance 20, une seconde résistance 21, et une seconde source de tension continue de polarisation 22, le point commun aux résistances 20 et 21 étant relié à la base B du transistor 14 via une troisième résistance 23.

Le collecteur C du transistor 19 est également relié au premier pôle de la source de tension continue de référence via une quatrième résistance 24 et une troisième source de tension continue de polarisation 25.

Le choix de cette structure particulière de l'amplificateur 3 en combinaison avec la résistance variable 10 permet d'obtenir les résultats suivants.

Lorsque la résistance variable 10 a une valeur nulle, le premier transistor de l'amplificateur 3 se bloque, entraînant le blocage de tous les transistors suivants.

On est alors sûr que les effets de la résistance variable ne se trouvent pas diminués par la présence d'un amplificateur qui pourrait occasionner une dérivation de courant vers la diode laser.

La structure de l'amplificateur de contre-réaction conforme à l'invention permet donc de bénéficier pleinement de l'efficacité du dispositif de protection conforme à l'invention.

**Revendications**

1. Dispositif de protection d'une diode laser (1) alimentée par une source (6) d'un courant continu de polarisation ($I_o$) et par une source (8) d'un courant variable porteur d'information ($\Delta I$), les deux sources de courant étant montées en parallèle, caractérisé en ce que la source (6) de courant continu peut être branchée ou débranchée par un interrupteur (7) ; une résistance variable (10) étant arrangée en parallèle avec la source (8) de courant porteur d'information ; ladite résistance variable (10) prenant une valeur nulle lorsque l'interrupteur (7) est ouvert, une valeur pratiquement infinie lorsque l'interrupteur (7) est fermé et une valeur croissant ou décroissant progressivement entre des deux valeurs extrêmes selon que l'interrupteur (7) passe de l'état ouvert à l'état fermé ou de l'état fermé à l'état ouvert.

2. Dispositif selon la revendication 1, caractérisé en ce que la résistance variable (10) comporte un premier transistor à effet de champ (11) dont le drain (D) constitue une première borne de la résistance variable (10), une source de tension continue de polarisation (12), la grille (G) du premier transistor à effet de champ (11) étant connectée à un premier pôle de la source de tension continue de polarisation (12) à travers un circuit de temporisation (14), la source (S) du premier transistor à effet de champ (11) et un second pôle de la source de tension continue de polarisation (12) étant reliés entre eux pour former une seconde borne de la résistance variable (10), l'établissement et la coupure de la tension continue de polarisation et du courant continu de polarisation étant commandés simultanément.

3. Dispositif selon la revendication 2, caractérisé en ce que le circuit de temporisation (14) comporte une résistance (16) dont une première borne est connectée au premier pôle de la source de tension continue de polarisation (12) et un condensateur (15) dont une première borne est connectée à une seconde borne de la résistance (16) et dont une seconde borne est connectée au second pôle de la source de tension continue de polarisation (12), le point commun à la résistance (16) et au condensateur (15) étant connecté à la grille G du premier transistor à effet de champ (11).

4. Dispositif selon l'une des revendications 1 ou 2, caractérisé en ce que la résistance variable (10) comporte également un second transistor à effet de champ (17) dont la grille (G) est connectée au premier pôle de la source de tension continue de polarisation (12), dont le drain (D) est connecté à la grille (G) du premier transistor à effet de champ (11), et dont la source (S) est connectée au second pôle de la source de tension continue de polarisation (12).

5. Dispositif selon l'une des revendications 1 à 4, dans lequel la branche directe du système de contre-réaction comporte un amplificateur de contre-réaction (3), caractérisé en ce que l'amplificateur de contre-réaction (3) est réalisé au moyen de « n » générateurs-amplificateurs montés en cascade (« n » étant un entier positif), l'entrée du premier générateur-amplificateur étant connectée au point commun à la résistance variable (10) et à la source (8) de courant porteur d'informations.

**Claims**

1. A device for protecting a laser diode (1) which is fed by a source (6) of a DC polarisation current ($I_o$) and by a source (8) of a variable current bearing an information ($\Delta I$), the two current sources being connected in parallel, characterized in that the DC source (6) can be enabled and disabled by a switch (7) ; a variable resistor (10) being branched in parallel to the source (8) of the information bearing current ; said resistor (10) providing zero resistance when the switch (7) is open, infinite resistance when the switch (7) is closed and a progressively increasing or decreasing resistance value between these two extreme values of the switch (7) passes from the open to the closed state or vice versa.

2. A device according to claim 1, characterized in that the variable resistor (10) comprises a first field effect transistor (11), the drain of which constitutes a first terminal of the variable resistor (10), a source of direct polarisation voltage (12), the grid (G) of the first field effect transistor (11) being connected to a first pole of the source of direct polarisation voltage (12) via a delay circuit (14), the source electrode (S) of the first field effect transistor (11) being connected to a second pole of the source of direct polarisation voltage (12), this connection constituting a second terminal of the variable resistor (12), enabling and disabling the direct polarisation voltage and the direct polarisation current being controlled simultaneously.

3. A device according to claim 2, characterized in that the delay circuit (14) comprises a resistor (16), the first terminal of which is connected to a first pole of the source of direct polarisation voltage (12), and a capacitor (15), the first terminal of which is connected to a second terminal of the resistance (16) and the second terminal of which is connected to the second pole of the source of direct polarisation voltage (12), the common point between the resistor (16) and the capacitor (15) being connected to the grid (G) of the first field effect transistor (11).

4. A device according to one of the claims 1 or 2, characterized in that the variable resistor (10) further comprises a second field effect transistor (17), the grid (G) of which is connected to the first pole of the source of direct polarisation voltage (12), the drain (D) of which is connected to the grid (G) of the first field effect transistor (11) and the source electrode (S) of which is connected to the second pole of the source of direct polarisation voltage (12).

5. A device according to one of the claims 1 to 4, in which the direct branch of the feedback system comprises a feedback amplifier (3), characterized in that the feedback amplifier (3) is made of a cascade arrangement of « n » generators-amplifiers (« n » being a positive integer), the input of the first generator-amplifier being connected to a common point between the variable resistor (10) and the source (8) of current which bears informations.

**Ansprüche**

1. Schutzvorrichtung für eine Laserdiode (1), die aus einer Polarisationsquelle (6) mit Gleichstrom ($I_o$) und aus einer Quelle (8) mit einem variablen, eine Information tragenden Strom ($\Delta I$) gespeist wird, wobei die beiden Stromquellen parallel zueinander geschaltet sind, dadurch gekennzeichnet, die Gleichstromquelle (6) über einen Unterbrecher (7) zugeschaltet bzw. abgeschaltet werden kann und ein variabler Widerstand (10) parallel zur Quelle (8) des die Information tragenden Stroms angeordnet ist, wobei dieser variable Widerstand (10) einen Wert null, wenn der Unterbrecher (7) offen ist, einen Wert unendlich, wenn der Unterbrecher (7) geschlossen ist, und einen zwischen diesen Grenzwerten zunehmenden bzw. abnehmenden Wert annimmt, wenn der Unterbrecher (7) vom offenen in den geschlossene Zustand oder umgekehrt übergeht.

2. Vorrichtung nach Anspruch 1, dadurch gekennzeichnet, daß der variable Widerstand (10) einen ersten Feldeffekttransistor (11), dessen Drainelektrode (D) einen ersten Anschluß des variablen Widerstands (10) bildet, und eine Polarisations-Gleichspannungsquelle (12) aufweist, wobei das Gitter (G) des ersten Feldeffekttransistors (11) mit dem ersten Pol der Polarisations-Gleichspannungsquelle (12) über einen Verzögerungsschaltkreis (14) verbunden ist und die Source-Elektrode (S) des ersten Feldeffekttransistors (11) sowie ein zweiter Pol der Polarisations-Gleichspannungsquelle (12) miteinander verbunden sind, um einen zweiten Anschluß des variablen Widerstands (10) zu bilden, und daß die Durchschaltung und Unterbrechung der Polarisationsgleichspannung und des Polarisationsgleichstroms gleichzeitig gesteuert werden.

3. Vorrichtung nach Anspruch 2, dadurch gekennzeichnet, daß der Verzögerungsschaltkreis (14) einen Widerstand (16), dessen erster Anschluß an den ersten Pol der Polarisations-Gleichspannungsquelle (12) angeschlossen ist, und einen Kondensator (15) aufweist, dessen erster Anschluß mit dem zweiten Anschluß des Widerstands (16) verbunden ist und dessen zweiter Anschluß mit dem zweiten Pol der Polarisationsgleichspannung (12) verbunden ist, während der gemeinsame Punkt zwischen dem Widerstand (16) und dem Kondensator (15) an das Gitter (G) des ersten Feldeffekttransistors (11) angeschlossen ist.

4. Vorrichtung nach einem der Ansprüche 1 oder 2, dadurch gekennzeichnet, daß der variable Widerstand (10) außerdem einen zweiten Feldeffekttransistor (17) aufweist, dessen Gitter (G) mit dem ersten Pol der Polarisationsgleichspannungsquelle (12), dessen Drainelektrode (D) mit dem Gitter (G) des ersten Feldeffekttransistors (11) und dessen Sourceelektrode (S) mit dem zweiten Pol der Polarisationsgleichspannungsquelle (12) verbunden ist.

5. Vorrichtung nach einem der Ansprüche 1 bis 4, in der der direkte Zweig des Rückkopplungssystems einen Rückkopplungsverstärker (3) enthält, dadurch gekennzeichnet, daß der Rückkopplungsverstärker (3) aus « n » in Kaskade verbundenen Generatoren-Verstärkern besteht (« n » ist eine positive ganze Zahl), wobei der Eingang des ersten Generator-Verstärkers mit dem gemeinsamen Punkt zwischen dem variablen Widerstand (10) und der Quelle (8) des die Information tragenden Stroms verbunden ist.

Fig.1

Fig.2

Fig.3

Fig.4